(19) Europäisches Patentamt

European Patent Office

Office européen des brevets

(11) **EP 3 673 516 B1**

(12) **EUROPEAN PATENT SPECIFICATION**

(45) Date of publication and mention of the grant of the patent:
**06.10.2021 Bulletin 2021/40**

(21) Application number: **18768979.9**

(22) Date of filing: **24.08.2018**

(51) Int Cl.:
*H01L 31/048* (2014.01)    *H02S 20/22* (2014.01)
*H02S 40/20* (2014.01)

(86) International application number:
**PCT/NL2018/050552**

(87) International publication number:
**WO 2019/039942 (28.02.2019 Gazette 2019/09)**

(54) **METHOD FOR PROVIDING A PHOTOVOLTAIC MODULE**

VERFAHREN ZUR HERSTELLUNG EINES PHOTOVOLTAIKMODULS

PROCÉDÉ DE FOURNITURE D'UN MODULE PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2017 NL 2019442**

(43) Date of publication of application:
**01.07.2020 Bulletin 2020/27**

(73) Proprietor: **Solar Visuals B.V.**
**1724 BD Oudkarspel (NL)**

(72) Inventors:
• **VAN ROOSMALEN, Johannes Adrianus Maria**
**1755 LE Petten (NL)**
• **BLOKKER, Peter**
**1724 BD Oudkarspel (NL)**
• **SLOOFF-HOEK, Lenneke Hendrika**
**1755 LE Putten (NL)**
• **SEPERS, Thijs**
**1724 BD Oudkarspel (NL)**
• **GIJZEN, Ger**
**2051 GL Overveen (NL)**
• **MINDERHOUD, Tom**
**1724 BD Oudkarspel (NL)**
• **WANG, Ningzhu**
**1111 AJ Amsterdam (NL)**

(74) Representative: **Nederlandsch Octrooibureau**
**P.O. Box 29720**
**2502 LS The Hague (NL)**

(56) References cited:
**WO-A1-02/21602**          **WO-A1-2014/174162**
**DE-U1-202012 102 494**    **US-A1- 2010 000 134**
**US-A1- 2012 247 541**     **US-A1- 2016 218 234**

## Description

### Field of the invention

The present invention relates to a method for providing a photovoltaic module having one or more photovoltaic cells, the method comprising providing a print on a foil and laminating the foil as part of the photovoltaic module.

### Background art

US patent publication US2016/0218234 discloses a method to provide graphic layers having visible images and/or patterns, which can be incorporated into solar modules. The graphic layers are provided in a solar module as a (stack of) separate layer(s) on top of an array of solar cells. The graphic layer is obtained from e.g. an image or picture, using a pixelation technique to provide a plurality of substantially opaque isolated regions (or pixels). The then defined pixels in combination contribute to the appearance of a recognizable image. In a specific embodiment, also isolated regions are defined which are used as masking regions/lines to cover otherwise visible components or features of the underlying solar module (such as wires, connectors, etc.), whose appearance without masking would be less desirable to the overall appearance of the image.

### Summary of the invention

The present invention seeks to provide an aesthetically attractive photovoltaic module which retains a high efficiency.

According to the present invention, a method as defined above is provided, wherein providing the print comprises applying a rasterization algorithm on an image to provide a pattern of dots, wherein dot locations of the pattern of dots are aligned with predetermined types of a surface area of a front side of the photovoltaic module. The predetermined types of surface areas are aligned with parts of the photovoltaic module which in operation shield radiation from reaching the one or more photovoltaic cells.

This allows to achieve a higher performance in a photovoltaic module compared to a pixelated pattern incorporated into a photovoltaic module which does not take into account the underlying metallization pattern.

### Short description of drawings

The present invention will be discussed in more detail below, with reference to the attached drawings, in which:

Fig. 1 shows a schematic representation of geometrical properties of rasterization method in a single structure,

Fig. 2 shows a schematic representation of geometrical properties of rasterization method in multiple structures,

Fig. 3 shows a cross sectional view of a photovoltaic module, and

Fig. 4A and 4B show an example of an image and a top view of a photovoltaic module provided with a rendering of the image, respectively, obtained in accordance with one of the present invention embodiments.

### Description of embodiments

Traditional photovoltaic (PV) panels or modules comprise a plurality of photovoltaic cells arranged in a specific lay out. These photovoltaic cells have metallised thin rectangular shaped strips (also called bus bars) which are printed on its front and/or on its rear side. Perpendicular to the strips metallic and thin grid fingers are present which are conductively connected to the strips. The current-conducting strips and fingers, or metallization pattern, are typically printed onto the surface using e.g. screen printing. The surface of a conventional photovoltaic cell is thus characterized by a grid of fine, current-collecting metallization pattern, typically having a silver colour appearance. Consumers are becoming hesitant to install these traditional types of photovoltaic panels on their buildings (e.g. roof tops, facades) or on other structures as the traditional types of photovoltaic panels with its screen printed fingers change the aesthetics of these buildings. A desire exists to be able to design and install more attractive and publicly acceptable photovoltaic modules using e.g. customised graphics or images. Apart from the infrastructure based applications, aesthetically attractive photovoltaic modules do find applications in other areas such as Building Integrated photovoltaic installations, Building Attached photovoltaic installations or in landscape Integrated photovoltaic installations. Alternatively, there may be a desire for business owners to be able to cover their photovoltaic modules with some kind of branding, serving as advertising to passers-by. The present invention seeks to provide an aesthetically pleasing photovoltaic module with a sufficiently high efficiency compared to other traditional photovoltaic modules.

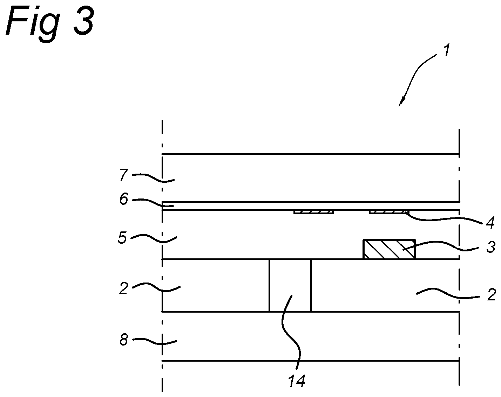

The process of manufacturing a photovoltaic module 1 comprises different steps, which is described with reference to the cross sectional view of a photovoltaic module 1 as shown in Fig. 3. A number of photovoltaic cells 2 are positioned on a back sheet 8, with spaces 14 (or scribe lanes) in between the (generally rectangular) photovoltaic cells 2. On each photovoltaic cell 2 a (front) metallization 3 is present, which effectively shields radiation impinging on the active area of the photovoltaic cell 2. An encapsulant layer 5 (e.g. of EVA material) is provided (also extending in the scribe lanes 14 between adjacent photovoltaic cells 2) on top, as well as a transparent (e.g. glass) top sheet 7. According to the present invention embodiments, in addition a foil 6 is provided having a pattern of dots 4. As will be explained below, the dots 4 are aligned with predetermined types of surface areas of the photovoltaic cell 2, such as the metallization pattern 3 or edge of a photovoltaic cell as shown in the embodiment of Fig. 3. The stack of back sheet 8, photovoltaic cells 2, encapsulant layer 5, foil 6 with pattern of dots 4, and transparent top sheet 7 are then laminated together to form a complete photovoltaic module 1.

It is noted that the exact position of the foil 6 and of the pattern of dots 4 in the stack of layers of the photovoltaic module 1 may be different in further embodiments of the present invention. Furthermore, the pattern of dots 4 may be provided on the inner surface of the foil 6 (the pattern of dots 4 being protected by the foil 6 against e.g. deterioration by solar/UV radiation), or alternatively on the outer surface of the foil 6. In addition, the transparent top sheet 7 may be made of glass as optionally indicated above, or alternatively from other transparent material, such as (UV-stabilized) PET, ETFE, PTFE, PC, PMMA, etc. with or without protective coatings. This may even be applied in an alternative stack arrangement, wherein the foil 6 (with pattern of dots 4) is forming the outer layer of the photovoltaic module 1. The stack of layers forming the photovoltaic module 1 could then comprise back sheet 8, photovoltaic cells 2, encapsulant layer 5 and a single front layer with pattern of dots 4 only.

Foil 6 may be a material having encapsulant characteristics, e.g. EVA, PVB, or more general, polyolefins, ionomers, silicones, etc In addition or alternatively, the pattern of dots 4 may be provided directly on the encapsulant layer 5. The foil 6 with pattern of dots 4 may then form an additional encapsulant layer or even replace the encapsulant layer 5 in the stack of layers described above.

Alternatively, the foil 6 may be of a material not having encapsulant characteristics by itself, in which case an additional encapsulant material layer may be provided between foil 6 and transparent top sheet 7.

Accordingly, an embodiment of the present invention relates to a method wherein the photovoltaic module 1 comprises a stack of the following layers: a layer with the one or more photovoltaic cells 2, the foil 6 with the pattern of dots 4, an encapsulant layer 5, and a transparent front sheet 7.

Common industrial photovoltaic module production is e.g. based on widely available screen-printed H-patterned silicon photovoltaic cells 2. Such photovoltaic cells 2 comprise a conducting metallization pattern 3 typically printed onto the front surface of each photovoltaic cell 2. These photovoltaic cells and consequently the associated photovoltaic module 1 suffer from a relatively high front surface shading and from series resistance losses in the interconnecting material between photovoltaic cells 2 (also indicated as 'tabs'). Both loss mechanisms are caused by the presence of (metal) strips (tabs, bus bars and fingers) printed onto the front surface where the radiation impinges. To reduce these losses, variants of photovoltaic cells 2 are known wherein the current contact terminals are all positioned on a back side of the photovoltaic cell 2, e.g. Metal Wrap Through (MWT) photovoltaic cells 2. The MWT technology comprises two additional process steps for cell production in comparison to the conventional technologies which are used for providing an H-patterned silicon photovoltaic cell 2. These additional steps are drilling (e.g. via a laser) and rear contact isolation. Thus, instead of having interconnecting wires (bus bars and tabs) running across the front surface, holes or vias are provided in the photovoltaic cells 2 to make electrical contacts through them. On the front surface of the MWT photovoltaic cell 2 a metallization pattern is provided with a very fine finger pattern radiating across the front surface, effectively blocking much less of the front surface of the active material of the photovoltaic cell 2. Compared to using a grid and tabs in an H-patterned photovoltaic cell 2, the MWT technology can as much as halve the amount of light blockage allowing high efficiency while production costs are still acceptable.

According to a first aspect of the present invention, a method is provided which allows to obtain a photovoltaic module 1 having a more aesthetic front surface. The method for providing a photovoltaic module 1 having one or more photovoltaic cells 2 comprises providing a print on a foil 6 and laminating the foil 6 as part of the photovoltaic module 1. Providing the print comprises applying a rasterization algorithm on an image to provide a pattern of dots 4, wherein dot locations of the pattern of dots 4 are aligned with predetermined types of a surface area of a front side of the photovoltaic module 1. The predetermined types of surface areas are aligned (or coincide) with parts 3 of the photovoltaic module 1 which in operation shield radiation from reaching the one or more photovoltaic cells 2.

The predetermined types of surface areas e.g. comprise the metallization pattern 3 on the front sides of the photovoltaic cells 2, and additionally or alternatively comprises an edge 13 of individual photovoltaic cells 2 and/or (photovoltaic) non-active areas of the photovoltaic module 1, such as a space 14 between adjacent photovoltaic cells 2. The space 14 is e.g. a scribe lane in case of rectangular cells, or differently shaped areas e.g. in case of semi-square (monocrystalline) cells 2.

The rasterization algorithm can be any one of rasterization or pixelation techniques, which as such are known, to transform an image or picture into characteristics of the pattern of dots 4, i.e. by determining appearance parameters of each individual dot in the pattern of dots 4 (presence, diameter, colour, shape, etc.). E.g. an image described in a vector graphics format can be converted into a raster image (e.g. pixels or dots). The present invention method embodiments translate the image into a pattern of dots 4 by means of the rasterization algorithm, wherein the individual dots of the pattern of dots 4 are placed and sized in a manner following as much as possible the pattern of the underlying photovoltaic cell metallization pattern 3 and other structures in the photovoltaic module 1. The pattern of dots 4 is e.g. implemented using a print on the foil 6,

In one group of embodiments of the present invention a method is provided wherein the predetermined types of surface area correspond to a metallization pattern 3 of an individual photovoltaic cell 2 of the one or more photovoltaic cells 2, and the pattern of dots 4 comprises equidistant dot locations. This allows to provide an appearance of the image when using photovoltaic cells 2 with e.g. a rectangular type of metallization pattern 3 such as in the case of a regular H-pattern photovoltaic cell 2, or in the case of a thin film cell 2 based photovoltaic module 1, e.g. having rectangular interconnection patterns, the present method embodiment can be applied as well.

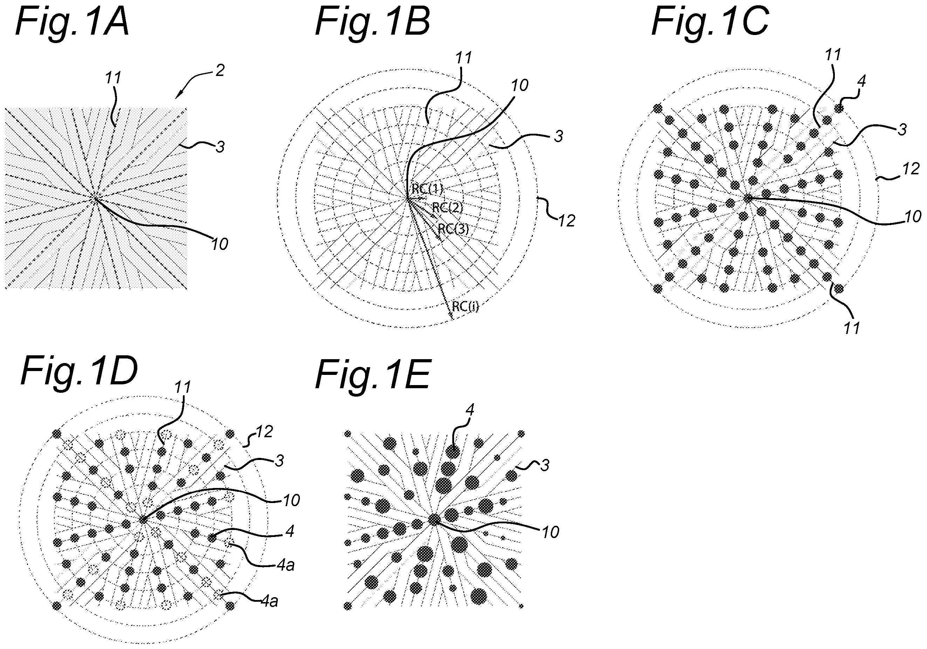

A further group of embodiments of the present invention relates to a method, wherein the predetermined types of surface area correspond to a metallization pattern 3 of an individual photovoltaic cell 2 of the one or more photovoltaic cells 2 and the pattern of dots 4 are provided by determining a plurality of radials 11 extending from a cell focus point 10, the plurality of radials 11 coinciding with a part of the metallization pattern 3, determining a plurality of circles 12 around the cell focus point 10 with increasing circle radius RC(i), and defining dot locations on intersections of the plurality of radials 11 and the plurality of circles 12. These method steps are illustrated by reference to the examples of a metallization pattern 3 of an MWT type of photovoltaic cell 2 as shown in Fig. 1A-E.

Fig. 1A shows a top view of a metallization pattern 3 for a MWT type of photovoltaic cell 2. The fine wire fingers of this metallization pattern 3 are arranged in a direction extending in a general radial sense from a cell focus point 10, in this case the center point of the photovoltaic cell 2. The method embodiments described herein implement coupling of a design, image or a picture which the consumer wants, into the pattern of dots 4 of the photovoltaic module 1, by using as much as possible of the area covered by the metallization pattern 3 of the photovoltaic cells 2 (and other structures in the photovoltaic module 1 such as the 'white' spaces or scribe lanes 14 between individual photovoltaic cells 2, the conductive tabs interconnecting individual photovoltaic cells 2, and possible even a perimeter of photovoltaic module 1 (outside of the array of photovoltaic cells 2), as will be explained in further detail below. This aims to create an appearance of the photovoltaic module 1 that is visually appealing and strong to a viewer, yet retaining a high as possible efficiency and performance of the photovoltaic module 1.

The radials 11 of the photovoltaic cell 2 can be derived from a geometrical pattern which can be customised according to the requirement. Typically, a parameter called branch number (Bn) is determined to indicate the number of radials 11 branching from the cell focus point 10. The MWT pattern shown in Fig.1A has a Bn value of 12, wherein each radial 11 coincides with an associated part of the underlying metallization pattern 3.

In a further embodiment of the present invention a circle radius of the plurality of circles 12 is equal to an integer times of a maximum predetermined dot radius, as shown in Fig. 1B. If the radius of the $i$th circle 12 is denoted by RC(i) and the maximum predetermined dot radius is denoted by $R_d(max)$, then RC(i) and $R_d$ are related to each other by RC(i) = $i*R_d(max)*2$. Factors determining the maximum predetermined dot radius may be depending upon the metallization pattern width, or on e.g. desired maximum surface coverage of the pattern of dots 4 (allowing sufficient radiation to actually enter the photovoltaic cells 2). At the maximum predetermined dot radius $R_d(max)$ two adjacent dots would then just touch each other. Note that similarly, a minimum predetermined dot size $R_d(min)$ may be selected, e.g. based on a minimum possible printing size of dots on the foil 6, which may also take into account a printing tolerance.

Furthermore, the pattern of dots is determined by the further steps of locating a dot at each of the four corners of the photovoltaic cell 2, i.e. on the extremities of the radials 11 as shown in Fig. 1C. Then, dots on the circles 12 are assigned in the dot pattern using a parameter representing the number of dots on the $i$th circle (DiN) given by the relation DiN = (Round (i/2)+(0|1))$^*$Bn/2. Thus for the first circle in Fig. 1A, with a branch number of 12, a DiN value of 6 is determined.

As shown in Fig. 1C, this may result in a pattern of dots 4 having a too uneven distribution of dots 4. In a further embodiment of the present invention the method further comprises removing a predetermined number of dot locations 4a in the pattern of dots 4, as shown by the open circles 4a in Fig. 1D. This is executed using a further rasterization parameter, a minimum spacing of dots Sdm. When dot spacing between adjacent dots 4 on the same radial 11 or circle 12 is less than the minimum spacing of dots, one dot is removed. Additionally a certain number of dots 4 may be removed randomly, or e.g. based on an interference image greyscale reduction rate, where the parameter reduction rate (RR) is directly proportional to a desired image greyscale (Gs), RR= k*Gs.

Using the rasterization algorithm, the radius of each dot in the pattern of dots 4 (dot radius) is calculated depending the intended image for the photovoltaic module, resulting in the pattern of dots 4 as shown in Fig. 1E, wherein each dot 4 now has a different radius. The maximum dot radius Rd(max) may also depend on further parameter calculation range factors (CrF).

In an embodiment, the dot radius Rd is calculated in accordance with the formula:

$$Rd=(CrF1*Gs+CrF2)*f(Gs)*RND(CrF3, CrF4)$$

First a grey scale value Gs for a part of the image is determined, which value is generally in the range 0...255.

In the first term of the above formula, the grey scale value Gs is adapted using two parameters CrF1 and CrF2 to translate the integer number Gs in a range of 0...255 to a value usable to provide a dot radius Rd, which in general is within a range of 0.5...2.5 mm.

Then a control curve f(Gs) is applied for adjusting the dot point scale distribution, such as more bigger points or more smaller point. This allows for small gradual adjustments based on the greyscale, both for coverage percentage and aesthetics. Finally a randomization parameter function is applied RND(CrF3, CrF4), which is used to create random effects.

Note that if the above equation would provide a small value, it is possible to additionally apply a lower limit for the dot radius Rd (if Rd< Rd(min), Rd = Rd(min), wherein Rd(min) is dependent on the printer characteristics, such as the printing tolerance T.

In addition the viewing distance may be considered in relation to the parameter maximum dot radius Rd(max) and dependent on the physical properties of the human eye. The maximum dot range Rd(max) thus relates to the intended viewing distance of the photovoltaic module 1, as the farther away a person is, the more the individual dots of the pattern of dots 4 will 'disappear' and provide a smooth visual effect linking to the visible pixel distance of the human eye. In order to achieve a smooth and fine rasterization, the Rd(max) parameter needs to meet the size requirement for different view distance. If Rd(max) is larger than the size requirement, the dot effects and dot pattern will become more obvious rather than the overall image. E.g. for a viewing distance of 20-100m, the maximum dot radius is 8 mm, but if the viewing distance is 10-50m, the dot radius should be less than 4 mm. In case the viewing distance is even lower (e.g. 4-20m) the maximum dot size is even (much) less than 1.5 mm, e.g. 0.3 mm.

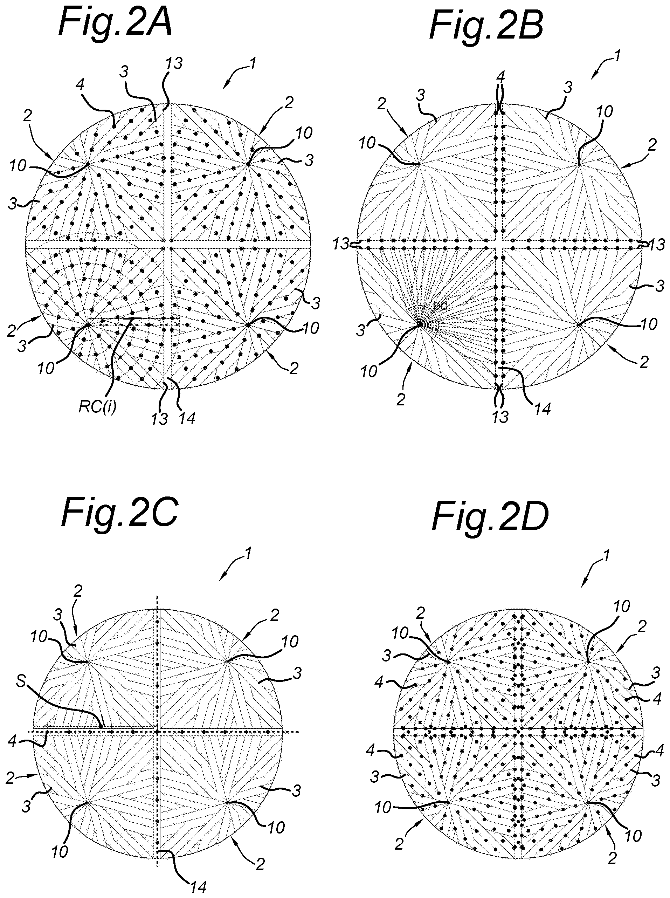

Fig. 2A-D show a schematic representation of geometrical properties used in further embodiments of the rasterization method in a structure of a photovoltaic module 1 having four photovoltaic cells 2 of the MWT type arranged to form an entire circle, i.e. four direct neighbouring photovoltaic cells 2. Fig. 2A shows the circular arrangement of the pattern of dots 4 obtained by the method described with reference to Fig. 1A-E for each photovoltaic cell 2. Fig. 2A shows (corner parts of) the four photovoltaic cells 2, each having a metallization pattern 3, cell focus point 10 and a pattern of dots 4. Each photovoltaic cell 2 has two perpendicular edges 13, and in between two adjacent photovoltaic cells 2 a space 14 (or scribe lane) is present.

A further embodiment of the present invention relates to a method comprising defining dot locations in the pattern of dots 4 on intersections of the plurality of radials 11 with edges 13 of the individual photovoltaic cell 2. The plurality of radials 11 may coincide with the radials 11 as used in the embodiments described above, but alternatively (as shown in Fig. 2B) a higher number of radials 11 may be used, not coinciding with the metallization pattern 3. As only dots 4 are added at the edges 13, the influence on photovoltaic module efficiency is then still minimal. As also shown in Fig. 2B, this will result in dots 4 being placed at the edge 13 of each of the metallisation patterns 3 finally resulting in having dots 4 at the edge of each individual photovoltaic cell 2. Note that the distance between dots 4 varies because of the varying distance from the cell focus point 10 and the equal angular spacing eq between the radials 11, in the embodiment shown.

In an even further embodiment of the present invention the pattern of dots 4 comprises dot locations in the space 14, e.g. scribe lane, between two adjacent photovoltaic cells 2, as shown in Fig. 2C. The additional dots may be positioned equidistantly as shown with a scribe lane dot distance S. Most of the radiation impinging on those locations would anyway not contribute to efficiency of the photovoltaic module 1, so adding dots 4 in these areas will not influence the efficiency very much.

When combining all dots, the pattern of dots 4 results as shown in Fig. 2D. Similar to the explanation with reference to Fig. 1D, some of the dots 4 may then again be removed in order to obtain a pattern of dots 4 which is most suited for rasterization of the image. It is noted that in an even further embodiment of the present invention the pattern of dots 4 may comprise dot locations in a perimeter area of the photovoltaic module 1, i.e. outside of the array of (active) photovoltaic cells 2. As a result, the entire frontal surface of a photovoltaic module 1 can be used to obtain the image to visually appear.

When determining which dots in the pattern of dots 4 are to be removed, it is also possible to take into account whether a (coloured) part of the image corresponds to a colour of the photovoltaic module background (usually solar cells 2 and/or back sheet 8, which may be black or dark blue or other colours). If such a match is present, the respective dots can be left out (or defined with a very small dot radius Rd), further enhancing the efficiency of the photovoltaic module 1.

A further embodiment of the present invention relates to a method further comprising determining a dot size for each individual dot of the pattern of dots 4 based on the image. As mentioned above this may be obtained using any rasterization or pixelation technique, and as an important parameter may include taking into account the expected viewing distance from the photovoltaic module 1.

An additional embodiment of the present invention comprises determining a dot shape for each individual dot of the pattern of dots 4 based on the image. The dot shape can be e.g. an elliptical shape, with a main axis aligned with the radials 11 in case of an MWT type of photovoltaic cell 2. The selected dot shape is effective to improve the efficiency benefit even further or along the fingers in case of an H-pattern type of photovoltaic cell or along the interconnection direction in case of a thin film module, or any other shape, e.g. representing corporate logos, etc.

In a further embodiment of the present invention a dot colour is determined for each individual dot of the pattern of dots 4 based on the image. By colouring the dots in a desired manner either a grey scale or a coloured image can be visually provided as appearance of the photovoltaic module 1.

The colour choice for the dot colour may be single or multi-colour, and is e.g. selected from the colours cyan, magenta, yellow, white and black. From the pigmented colours cyan, magenta and yellow, yellow will provide the best efficiency of the photovoltaic module 1, followed by magenta and lastly cyan. By selecting a proper colour or colour palette to represent the image, optimization of photovoltaic module 1 performance may be achieved.

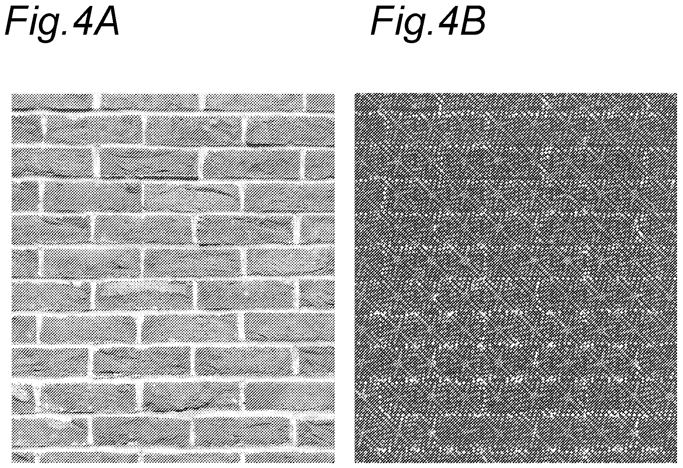

The image processed into a pattern of dots 4 in accordance with one of the present invention embodiment is e.g. be a rendering of a brick wall. Fig. 4A and 4B show an example of an image of a brick wall and a top view of a photovoltaic module 1 provided with a rendering of the brick wall image, respectively. In accordance with one of the present invention embodiments, the image of the brick wall is transformed into a pattern of dots 4 visible on the radiation receiving side of the photovoltaic module 1.

As discussed above, the foil 6 with pattern of dots 4 is part of the stack of layers which are laminated into the photovoltaic module 1. The foil comprises PET (polyethylene terephthalate) in a further embodiment or polyethylene naphthalate (PEN), polybutylene terephthalate (PBT), etc. This will help the photovoltaic module 1 to keep its shape during lamination, ensuring maintenance of alignment of the pattern of dots 4 with the predetermined types of a surface area (non-active parts) of the photovoltaic module. The foil 6 with pattern of dots 4 is placed deep into the photovoltaic module, e.g. behind the glass top layer 7, and possibly even behind a layer of encapsulant and behind (on the back side of) the foil 6 onto which the pattern of dots is printed. The encapsulant material is e.g. ethylene-vinyl acetate (EVA), polyvinyl butyral (PVB), etc., or more general, polyolefins, ionomers, silicones, etc. All structural layers above the pattern of dots 4 can help to filter out UV radiation, which is most damaging to pigments or inks used for providing the pattern of dots 4.

In a further embodiment, the pattern of dots 4 comprises a layer of colour substance (e.g. having a pigment or an ink) applied to a bottom surface of the foil 6. Depending on the desired result of appearance of the image on the photovoltaic module 1, a specific (combination of) substance(s) may be used, e.g. to obtain an image wherein two colours fade in and out.

To get an even more clear appearance of the image on the photovoltaic module 1, a white layer is applied to the layer of colour substance. The white layer is e.g. a reflecting layer which is printed over the pigments or inks that form the (full colour) pattern of dots 4 (in the stack of layers the white layer comes behind the colour substance. To improve the performance of the photovoltaic module 1, the white layer is selected simultaneously to be as reflective as necessary to provide a good colour appearance (with respect to the (black) background of cells 2 and back sheet 8), and as transmissive as possible to efficiently pass sufficient radiation onto the photovoltaic cells 2. Depending on the specific choice of components providing the white layer, it is possible to optimize for efficiency of the photovoltaic module 1. As an example, using a '100% white' colour substance, the layer would have about 38% transmission, and when using a '50% white' colour substance, the layer would have about 58% transmission. Note that this may also be dependent on the droplet size used when printing (bigger droplets result in a lower transmission).

A further optimization using one of the present invention embodiments may be to take into account the overall current delivery of individual photovoltaic cells 2 in a photovoltaic module 1. If connected in series, in an ideal situation each series connected photovoltaic cell 2 should provide an equal current. By ensuring that the rasterization algorithm (including the selection of colour, size and number of dots in the pattern of dots 4), takes into account the effect on possible current production of each photovoltaic cell 2 when composing the total image of the photovoltaic module 1, and keeping the possible current production for each photovoltaic cell 2 within a small range, the efficiency of the entire photovoltaic module 1 may be optimised.

A further enhancement of efficiency of the photovoltaic module 1 may be achieved by using a fill-in (transparent) print on (a part of) the foil 6, or selecting a foil 6 with the appropriate transparency, to fill in the space between the pattern of dots 4. The fill-in may be a very transparent print in order to hide the black/dark blue background of the photovoltaic module 1 (or to make it appear less black). The very transparent print may even be slightly coloured using conventional pigments (e.g. cyan, magenta, yellow).

The present invention has been described above with reference to a number of exemplary embodiments as shown in the drawings. Modifications and alternative implementations of some parts or elements are possible, and are included in the scope of protection as defined in the appended claims.

**Claims**

1. Method for providing a photovoltaic module (1) having one or more photovoltaic cells (2), comprising providing a print on a foil (6), and laminating the foil (6) as part of the photovoltaic module (1), wherein providing the print comprises:
   applying a rasterization algorithm on an image to provide a pattern of dots (4), wherein dot locations of the pattern of dots (4) are aligned with predetermined types of a surface area of a front side of the photovoltaic module (1), the predetermined types of surface areas being aligned with parts (3) of the photovoltaic module (1) which in operation shield radiation from reaching the one or more photovoltaic cells (2).

2. Method according to claim 1, wherein the predetermined types of surface area correspond to a metallization pattern (3) of an individual photovoltaic cell (2) of the one or more photovoltaic cells (2), and the pattern of dots (4) comprises equidistant dot locations.

3. Method according to claim 1, wherein the predetermined types of surface area correspond to a metallization pattern of an individual photovoltaic cell of the one or more photovoltaic cells (2), and the pattern of dots (4) are provided by

determining a plurality of radials (11) extending from a cell focus point (10), the plurality of radials (11) coinciding with a part of the metallization pattern (3),
determining a plurality of circles (12) around the cell focus point (10) with increasing circle radius (RC(i)),
defining dot locations on intersections of the plurality of radials (11) and the plurality of circles (12).

4. Method according to claim 3, wherein a circle radius (RC(i)) of the plurality of circles (12) is equal to an integer times of a maximum predetermined dot radius ($R_d$(max)).

5. Method according to claim 3 or 4, further comprising removing a predetermined number of dot locations (4a) in the pattern of dots (4).

6. Method according to any one of claims 3-5, further comprising
defining dot locations in the pattern of dots (4) on intersections of the plurality of radials (11) with edges (13) of the individual photovoltaic cell (2).

7. Method according to any one of claims 1-6, wherein the pattern of dots (4) comprises dot locations in a space (14) between two adjacent photovoltaic cells (2).

8. Method according to any one of claims 1-7, wherein the pattern of dots (4) comprises dot locations in a perimeter area of the photovoltaic module.

9. Method according to any one of claims 1-8, further comprising determining a dot size for each individual dot of the pattern of dots (4) based on the image.

10. Method according to any one of claims 1-9, further comprising determining a dot shape for each individual dot of the pattern of dots (4) based on the image.

11. Method according to any one of claims 1-10, further comprising determining a dot colour for each individual dot of the pattern of dots (4) based on the image.

12. Method according to any one of claims 1-11, wherein the photovoltaic module comprises a stack of the following layers: a layer with the one or more photovoltaic cells (2), the foil (6) with the pattern of dots (4), an encapsulant layer (5), and a transparent front sheet (7).

13. Method according to any one of claims 1-12, wherein the foil (6) comprises PET.

14. Method according to any one of claims 1-13, wherein the pattern of dots (4) comprises a layer of colour substance applied to a bottom surface of the foil (6).

15. Method according to claim 14, wherein the pattern of dots (4) additionally comprises a white layer applied to the layer of colour substance.

**Patentansprüche**

1. Verfahren zum Bereitstellen eines Photovoltaikmoduls (1) mit einer oder mehreren Photovoltaikzellen (2), aufweisend ein Bereitstellen eines Drucks auf einer Folie (6) und ein Laminieren der Folie (6) als Teil des Photovoltaikmoduls (1), wobei das Bereitstellen des Drucks aufweist:
Anwenden eines Rasterungsalgorithmus auf ein Bild, um ein Punktmuster (4) bereitzustellen, wobei Punktpositionen des Punktmusters (4) mit vorbestimmten Typen eines Oberflächenbereichs einer Vorderseite des Photovoltaikmoduls (1) ausgerichtet sind, wobei die vorbestimmten Typen von Oberflächenbereichen mit Teilen (3) des Photovoltaikmoduls (1) ausgerichtet sind, die im Betrieb Strahlung vom Erreichen der einen oder mehreren Photovoltaikzellen (2) abschirmen.

2. Verfahren nach Anspruch 1, wobei die vorbestimmten Typen von Oberflächenbereichen einem Metallisierungsmuster (3) einer einzelnen Photovoltaikzelle (2) der einen oder mehreren Photovoltaikzellen (2) entsprechen, und das Punktmuster (4) äquidistante Punktpositionen aufweist.

3. Verfahren nach Anspruch 1, wobei die vorbestimmten Typen von Oberflächenbereichen einem Metallisierungsmuster einer einzelnen Photovoltaikzelle der einen oder mehreren Photovoltaikzellen (2) entsprechen, und die Punktmuster (4) bereitgestellt werden durch

Bestimmen einer Vielzahl von Radialen (11), die sich von einem Zellenfokuspunkt (10) aus erstrecken, wobei die Vielzahl von Radialen (11) mit einem Teil des Metallisierungsmusters (3) übereinstimmt,
Bestimmen einer Vielzahl von Kreisen (12) um den Zellenfokuspunkt (10) mit zunehmenden Kreisradius (RC(i)),
Definieren von Punktpositionen an Schnittpunkten der Vielzahl von Radialen (11) und der Vielzahl von Kreisen (12).

4. Verfahren nach Anspruch 3, wobei ein Kreisradius (RC(i)) der Vielzahl von Kreisen (12) gleich einer ganzen Zahl mal einem maximalen vorbestimmten Punktradius ($R_d$(max)) ist.

5. Verfahren nach Anspruch 3 oder 4, ferner aufweisend ein Entfernen einer vorbestimmten Anzahl von Punktpositionen (4a) in dem Punktmuster (4).

6. Verfahren nach einem der Ansprüche 3 bis 5, ferner aufweisend ein Definieren von Punktpositionen in dem Punktmuster (4) an Schnittpunkten der Vielzahl von Radialen (11) mit Kanten der einzelnen Photovoltaikzelle (2).

7. Verfahren nach einem der Ansprüche 1 bis 6, wobei das Punktmuster (4) Punktpositionen in einem Raum (14) zwischen zwei benachbarten Photovoltaikzellen (2) aufweist.

8. Verfahren nach einem der Ansprüche 1 bis 7, wobei das Punktmuster (4) Punktpositionen in einer Umkreisfläche des Photovoltaikmoduls aufweist.

9. Verfahren nach einem der Ansprüche 1 bis 8, ferner aufweisend ein Bestimmen einer Punktgröße für jeden einzelnen Punkt des Punktmusters (4) basierend auf dem Bild.

10. Verfahren nach einem der Ansprüche 1 bis 9, ferner aufweisend ein Bestimmen einer Punktform für jeden einzelnen Punkt des Punktmusters (4) basierend auf dem Bild.

11. Verfahren nach einem der Ansprüche 1 bis 10, ferner aufweisend ein Bestimmen einer Punktfarbe für jeden einzelnen Punkt des Punktmusters (4) basierend auf dem Bild.

12. Verfahren nach einem der Ansprüche 1 bis 11, wobei das Photovoltaikmodul einen Stapel aus den nachstehenden Schichten aufweist: eine Schicht mit der einen oder mehreren Photovoltaikzellen (2), die Folie (6) mit dem Punktmuster (4), eine Einkapselungsschicht (5) und eine transparente Frontschicht (7).

13. Verfahren nach einem der Ansprüche 1 bis 12, wobei die Folie (6) PET aufweist.

14. Verfahren nach einem der Ansprüche 1 bis 13, wobei das Punktmuster (4) eine Schicht aus Farbsubstanz aufweist, die auf der Unterseite der Folie (6) aufgebracht ist.

15. Verfahren nach Anspruch 14, wobei das Punktmuster (4) zusätzlich eine weiße Schicht aufweist, die auf die Schicht der Farbsubstanz aufgebracht ist.

**Revendications**

1. Procédé pour fournir un module photovoltaïque (1) présentant une ou plusieurs cellules photovoltaïques (2), comprenant la fourniture d'une impression sur une feuille (6), et la stratification de la feuille (6) en tant que partie du module photovoltaïque (1), dans lequel la fourniture de l'impression comprend : une application d'un algorithme de tramage sur une image pour fournir un motif de points (4), dans lequel des emplacements de point du motif de points (4) sont alignés avec des types prédéterminés d'une aire de surface d'un côté avant du module photovoltaïque (1), les types prédéterminés d'aires de surface étant alignés avec des parties (3) du module photovoltaïque (1) qui, en fonctionnement, empêchent un rayonnement d'atteindre les une ou plusieurs cellules photovoltaïques (2).

2. Procédé selon la revendication 1, dans lequel les types prédéterminés d'aire de surface correspondent à un motif de métallisation (3) d'une cellule photovoltaïque individuelle (2) des une ou plusieurs cellules photovoltaïques (2), et le motif de points (4) comprend des emplacements de point équidistants.

3. Procédé selon la revendication 1, dans lequel les types prédéterminés d'aire de surface correspondent à un motif de métallisation d'une cellule photovoltaïque individuelle des une ou plusieurs cellules photovoltaïques (2), et le motif de points (4) est fourni par

la détermination d'une pluralité de radiales (11) s'étendant à partir d'un point focal de cellule (10), la pluralité de radiales (11) coïncidant avec une partie du motif de métallisation (3),
la détermination d'une pluralité de cercles (12) autour du point focal de cellule (10) avec un rayon de cercle croissant (RC(i)),
la définition d'emplacements de point sur des intersections de la pluralité de radiales (11) et de la pluralité de cercles (12).

4. Procédé selon la revendication 3, dans lequel un rayon de cercle (RC(i)) de la pluralité de cercles (12) est égal à un nombre entiers d'un rayon de points prédéterminé maximum (Rd(max)).

5. Procédé selon la revendication 3 ou 4, comprenant en outre l'élimination d'un nombre prédéterminé d'emplacements de point (4a) dans le motif de points (4).

6. Procédé selon l'une quelconque des revendications 3 à 5, comprenant en outre
la définition d'emplacements de point dans le motif de points (4) sur des intersections de la pluralité de radiales (11) avec des bords (13) de la cellule photovoltaïque individuelle (2).

7. Procédé selon l'une quelconque des revendications 1 à 6, dans lequel le motif de points (4) comprend des emplacements de point dans un espace (14) entre deux cellules photovoltaïques adjacentes (2).

8. Procédé selon l'une quelconque des revendications 1 à 7, dans lequel le motif de points (4) comprend des emplacements de point dans une aire de périmètre du module photovoltaïque.

9. Procédé selon l'une quelconque des revendications 1 à 8, comprenant en outre la détermination d'une taille de point pour chaque point individuel du motif de points (4) sur la base de l'image.

10. Procédé selon l'une quelconque des revendications 1 à 9, comprenant en outre la détermination d'une forme de point pour chaque point individuel du motif de points (4) sur la base de l'image.

11. Procédé selon l'une quelconque des revendications 1 à 10, comprenant en outre la détermination d'une couleur de point pour chaque point individuel du motif de points (4) sur la base de l'image.

12. Procédé selon l'une quelconque des revendications 1 à 11, dans lequel le module photovoltaïque comprend un empilement des couches suivantes : une couche avec les une ou plusieurs cellules photovoltaïques (2), la feuille (6) avec le motif de points (4), une couche d'encapsulation (5), et une feuille avant transparente (7).

13. Procédé selon l'une quelconque des revendications 1 à 12, dans lequel la feuille (6) comprend du PET.

14. Procédé selon l'une quelconque des revendications 1 à 13, dans lequel le motif de points (4) comprend une couche de substance de couleur appliquée à une surface inférieure de la feuille (6).

15. Procédé selon la revendication 14, dans lequel le motif de points (4) comprend en outre une couche blanche appliquée sur la couche de substance de couleur.

Fig. 1A

Fig. 1B

Fig. 1C

Fig. 1D

Fig. 1E

# Fig.2A

# Fig.2B

# Fig.2C

# Fig.2D

*Fig 3*

*Fig. 4B*

*Fig. 4A*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160218234 A